# EUROPEAN PATENT APPLICATION

(11) **EP 1 237 278 A1**
(43) Date of publication of application: **04.09.2002**
(21) Application number: 02396014.9
(22) Date of filing: 07.02.2002
(51) Int. Cl.: H03K 19/00, H03K 19/0185

(54) **Logic level shifting circuit**

(30) Priority: 28.02.2001 FI 20010404
(71) Applicant: Nokia Corporation, 02150 Espoo (FI)
(72) Inventor: Salminen, Veli-Matti, 90500 Oulu (FI)
(74) Representative: Walker, Andrew John

(57) **Abstract**

A level shifting circuit (500) is provided for shifting a first voltage level to a second voltage level. The level shift is done by two inverters (542, 543) connected in cascade. The input of the first inverter forms the input port (501) of the level shifting circuit (500) where the first voltage level is input. The output of the second inverter forms the output port (502) of the level shifting circuit (500) where the second voltage level is output. The level shifting circuit (500) is operated by a single operating voltage (V_{DD}). It further comprises a leakage current limiting circuit (541) connected in series between the first inverter (542) and the operating voltage (V_{DD}) to limit a leakage current through the logic level shifting circuit (500). The level shifting circuit (500) is particularly suited to use in shifting logical 1 levels in mobile telephones.

## Description

The invention relates to a CMOS inverter circuit. It is particularly related to a CMOS based logic level shifting circuit with single operating voltage and low leakage current.

Digital technology is based on logical ports dealing with binary numbers. Binary numbers only contain zeros and ones, which can be represented by two voltage levels. Logical 0s are represented by a voltage level essentially equal to a set ground level and logical 1s by a voltage level a few volts above the ground level. The voltage level of a logical 1 can be set to any level above the ground level and currently various voltages are used to represent the logical 1 depending on which circuit technology is used.

As long as all of the circuits of a device are using the same voltage level corresponding to the logical 1s there are no problems. However, in many cases it is necessary to combine units having different voltage levels corresponding to logical 1s. In these cases it is necessary to perform logic level shifting to make the output of one unit suitable as the input to another unit.

In digital mobile phones the logical ports are generally implemented inside integrated circuits. The design of integrated circuits generally aims at minimising the silicon area occupied and the number of connection pads needed.

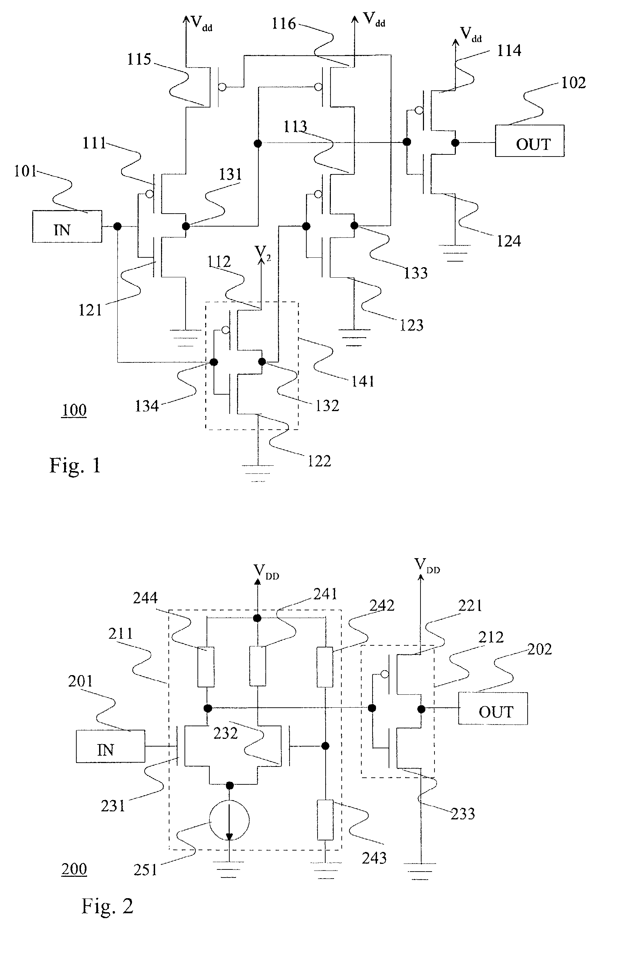

There are several different circuit solutions known in the prior art to perform level shifting. One solution is a level shifting circuit 100 shown in Figure 1.

In the level shifting circuit 100, when a voltage at an IN-port 101 is on a level corresponding to logical 1, NMOS transistors 121 and 122 conduct and ground nodes 131 and 132. As a result PMOS transistors 113, 114 and 116 conduct. The PMOS transistor 114 thus connects an OUT-port 102 to operating voltage V_{DD}. The PMOS transistors 113 and 116 being in a conductive state cause a node 133 to be connected to the operating voltage V_{DD}, which again shuts PMOS transistor 115 and prevents current flow through it.

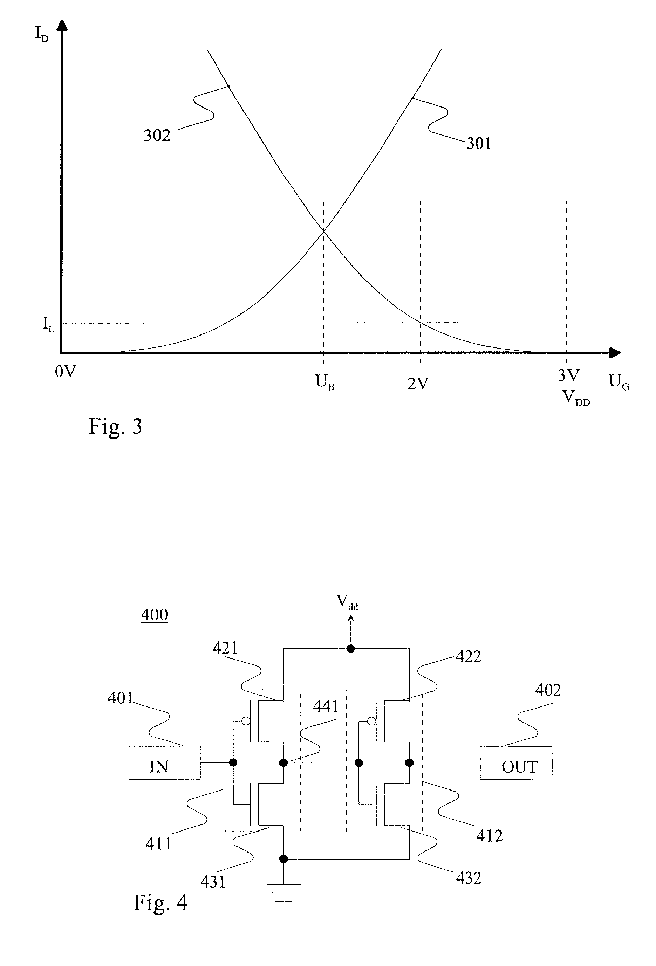

The level shifting circuit 100 is a circuit for switching the voltage level corresponding to logical 1 at the IN-port 101 to a higher voltage level corresponding to logical 1 at the OUT-port 102. The voltage level corresponding to the logical 1 at the OUT-port 102 is defined by the operating voltage V_{DD}. If the same operating voltage V_{DD} is also applied to PMOS transistor 112 a leakage current problem results. This is illustrated (in connection to Figure 1) by Figure 3, which illustrates voltage-current characteristics of a CMOS inverter 141 (see Figure 1). Gate voltage U_{G}, corresponding to the voltage at a node 134, is shown on the abscissa and drain current I_{D} on the ordinate. When the gate voltage U_{G} is zero the drain current I_{D} is also zero as can be seen by an NMOS curve 301. At the same time the PMOS transistor 112 is in a conducting state, but no current can go through it because it is connected in series with the NMOS transistor 122. As the gate voltage U_{G} starts rising towards the voltage level corresponding to logical 1 the drain current I_{D} can be seen to start rapidly rising until the current starts to be limited by the PMOS transistor 112, as illustrated by a PMOS curve 302, at a breakover point U_{B}. As the gate voltage U_{G} further rises the drain current I_{D} will be reduced to zero again as the gate voltage U_{G} reaches the operating voltage V_{DD}.

However, in a case where an operating voltage V₂ of the CMOS inverter 141 is higher than the voltage level corresponding to logical 1 at the IN-port 101 of the level shifting circuit 100, the gate voltage U_{G} never reaches the operating voltage V₂. Due to this, there remains a constant leakage current I_{L} through the CMOS inverter 141, which thus increases power consumption of the level shifting circuit 100. The leakage current I_{L} is in this case typically in the order of 10 µA. In order to avoid this, the CMOS inverter 141 has the operating voltage V₂. The operating voltage V₂ is set essentially equal to the voltage level corresponding to logical 1 at the IN-port 101, being thus lower than the operating voltage V_{DD} that is used by all the other parts of the level shifting circuit 100.

In the level shifting circuit 100, when the voltage at the IN-port 101 is on a level corresponding to logical 0, PMOS transistor 111 and the PMOS transistor 112 conduct. As a result the node 132 is connected to the operating voltage V₂. Accordingly NMOS transistor 123 conducts and grounds the node 133 to cause the PMOS transistor 115 to conduct and connect the node 131 to the operating voltage V_{DD} through the PMOS transistors 111 and 115. This causes NMOS transistor 124 to conduct and to ground the OUT-port 102. At the same, because the voltage at the node 132 is lower than the operating voltage V_{DD} the PMOS transistor 113 would not be completely shut, if it was connected directly to the operating voltage V_{DD}. However, the gate of the PMOS transistor 116 is connected to the operating voltage V_{DD} through the PMOS transistors 115 and 111 and is thus completely shut, hence preventing the leakage current flow also through the PMOS transistor 113.

The level shifting circuit 100 shown in Figure 1 is complex and requires a large area of silicon on an integrated circuit. It further necessitates one more operating voltage V₂ which also demands an extra connection pad to the integrated circuit. The operating voltage V₂ is typically obtained from another digital circuit, which makes it very noisy due to all the state changes inside the other digital circuit.

A solution for a level shifting circuit 200 with one single operating voltage is shown in Figure 2. An IN-port 201 side inverter 211 is formed by resistors 241, 242, 243 and 244, NMOS transistors 231 and 232 and a constant current generator 251. An OUT-port 202 side CMOS inverter 212 is similar to the CMOS inverter 141 of the level shifting circuit 100.

In a typical implementation the values for the resistors 242 and 243 are set equal to set the voltage at the gate of the NMOS transistor 232 in the middle of the voltage swing between an operating voltage V_{DD} and the ground potential, thus defining a breakover point U_{B} of the inverter 211.

An NMOS transistor has a channel conductance, which is proportional to the gate-to-source voltage. When a voltage at the IN-port 201 is on a level corresponding to a logical 0 the channel of the NMOS transistor 231 is completely shut and current flowing through the constant current generator 251 thus has to completely pass through the NMOS transistor 232. Because no current passes through the resistor 244, the gates of PMOS transistor 221 and NMOS transistor 233 are connected to the operating voltage V_{DD}. Thus, the NMOS transistor 233 conducts, connecting the OUT-port 202 to ground potential, which is corresponding to logical 0.

When the voltage at the IN-port 201 is on a level corresponding to logical 1 the channel of the NMOS transistor 231 is completely open and the current flowing through the constant current generator 251 has to completely pass through the NMOS transistor 231. At the same the gates of the PMOS transistor 221 and the NMOS transistor 233 are grounded, causing the PMOS transistor 221 to conduct, connecting the OUT-port 202 to the operating voltage V_{DD}, which is corresponding to logical 1.

The level shifting circuit 200 only needs one operating voltage V_{DD}, but the construction is still complicated and further has a problem of leakage current. The leakage current of the level shifting circuit 200 through the constant current generator 251 is typically in the order of 5 to 10 µA.

A straightforward solution for level shifting would be to provide a buffer circuit 400 as shown in Figure 4. The buffer circuit 400 comprises two CMOS inverters, a first CMOS inverter 411 comprising PMOS transistor 421 and NMOS transistor 431 and a second CMOS inverter 412 being formed by PMOS transistor 422 and NMOS transistor 432. Both of the CMOS inverters 411, 412 are connected to a common operating voltage V_{DD}.

When a voltage at an IN-port 401 is corresponding to logical 1, the NMOS transistor 431 conducts, thus grounding a node 441. As a result the PMOS transistor 422 conducts and an OUT-port 402 is connected to the operating voltage V_{DD}. If the voltage level corresponding to logical 1 level at the IN-port 401 is 2 volts and the operating voltage V_{DD} is 3 volts, a shift from a logical 1 level of 2 volts to a logical 1 level of 3 volts is carried out. However, because the voltage at the IN-port 401 does not reach the operating voltage V_{DD} there remains a leakage current I_{L} through the CMOS inverter 411.

When the IN-port 401 is connected to the voltage level corresponding to logical 0 the PMOS transistor 421 conducts. The node 441 is thus connected to the operating voltage V_{DD}. As a result, the NMOS transistor 432 conducts and connects the OUT-port 402 to a ground potential.

The buffer circuit 400 is not used for level shifting because of a serious problem of leakage current in the event that the voltage level corresponding to logical 1 at the IN-port 401 side of the buffer circuit 400 is lower than the operating voltage V_{DD}

Accordingly, there is clearly a need for a simple, low leakage level shifting circuit that is operated by a single operating voltage.

According to a first aspect of the invention there is provided a level shifting circuit for shifting a first voltage level to a second voltage level comprising a first inverter and a second inverter, an output of the first inverter being connected to an input of the second inverter, an input of the first inverter forming an input port of the level shifting circuit for inputting the first voltage level and an output of the second inverter forming an output port of the level shifting circuit for the second voltage level, the level shifting circuit being operated by a single operating voltage characterised in that the level shifting circuit further comprises a leakage current limiting circuit connected in series between the first inverter and the operating voltage for limiting a leakage current through the logic level shifting circuit in a situation when the first voltage level is below the operating voltage.

The level shifting circuit is preferably used for shifting logical levels, the first voltage level corresponding to a first logical 1 in a first digital circuit and the second voltage level corresponding to a second logical 1 in a second digital circuit. In a preferred embodiment of the present invention the operating voltage corresponds to the second voltage level. In another preferred embodiment at least one of the first and the second inverters is implemented by CMOS technology. The leakage current limiting circuit preferably comprises a PMOS transistor and a resistor by-passing the channel of the PMOS transistor. Preferably the resistor value is set to a value that does not substantially slow down the operation of the logic level shifting circuit. In a yet further preferred embodiment the resistor value is chosen from a range between 100 kΩ and 1 MΩ.

In a second aspect of the invention there is provided a digital logic circuitry comprising a plurality of subcircuits, each subcircuit using one of a plurality of voltage levels, a first voltage level of the plurality of voltage levels differing from a second voltage level of the plurality of voltage levels, a first subcircuit of the plurality of subcircuits being a level shifting circuit for shifting the first voltage level output from a second subcircuit of the plurality of subcircuits to the second voltage level for inputting to a third subcircuit of the plurality of subcircuits, the first subcircuit comprising a first inverter and a second inverter, an output of the first inverter being connected to an input of the second inverter, an input of the first inverter forming an input port of the first subcircuit for inputting the first voltage level and an output of the second inverter forming an output port of the first subcircuit for outputting the second voltage level, the first subcircuit being operated by a single operating voltage characterised in that the first subcircuit further comprises a leakage current limiting circuit connected in series between the first inverter and the operating voltage for limiting a leakage current through the first subcircuit in a situation when the first voltage level is below the operating voltage.

Preferably the second subcircuit is a digital logic circuit, in which the first voltage level is corresponding to a first logical 1, and the third subcircuit is another digital logic circuit, in which the second voltage level is corresponding to a second logical 1. In a preferred embodiment the operating voltage is corresponding to the second voltage level. In another preferred embodiment at least one of the first and the second inverters is implemented by CMOS technology. The leakage current limiting circuit preferably comprises a PMOS transistor and a resistor by-passing the channel of the PMOS transistor. Preferably the resistor value is set to a value that does not substantially slow down the operation of the first subcircuit. In a yet further preferred embodiment the resistor value is chosen from a range between 100 kΩ and 1 MΩ.

In a third aspect of the invention there is provided a mobile phone comprising a level shifting circuit for shifting a first voltage level, output from a first digital circuit, to a second voltage level for inputting to a second digital circuit, the level shifting circuit comprising a first inverter and a second inverter, an output of the first inverter being connected to an input of the second inverter, an input of the first inverter forming an input port of the level shifting circuit for inputting the first voltage level and an output of the second inverter forming an output port of the level shifting circuit for outputting the second voltage level, the level shifting circuit being operated by a single operating voltage characterised in that the level shifting circuit further comprises a leakage current limiting circuit connected in series between the first inverter and the operating voltage for limiting a leakage current through the logic level shifting circuit in a situation when the first voltage level is below the operating voltage.

The level shifting circuit is preferably used for shifting logical levels, the first voltage level corresponding to a first logical 1 and the second voltage level corresponding to a second logical 1. Preferably the first digital circuit and the second digital circuit are logical circuits handling binary data. In a preferred embodiment the operating voltage is corresponding to the second voltage level. In another preferred embodiment at least one of the first and the second inverters is implemented by CMOS technology. The leakage current limiting circuit preferably comprises a PMOS transistor and a resistor by-passing the channel of the PMOS transistor. Preferably the resistor value is set to a value that does not substantially slow down the operation of the logic level shifting circuit. In a yet further preferred embodiment the resistor value is chosen from a range between 100 kΩ and 1 MΩ.

The invention will be described by way of example only with reference to the accompanying drawings, in which:
Figure 1 shows a circuit known in the prior art for performing a logical level shift with two operating voltages;
Figure 2 shows a solution for performing a logical level shift with a single operating voltage;
Figure 3 shows a typical UI curve of a CMOS circuit;
Figure 4 shows a simple solution for performing a logical level shift with a single operating voltage using a buffer circuit;
Figure 5 shows a logical level shifting circuit according to the present invention;
Figure 6 a shows a mobile phone incorporating a logical level shifting circuit according to the present invention; and

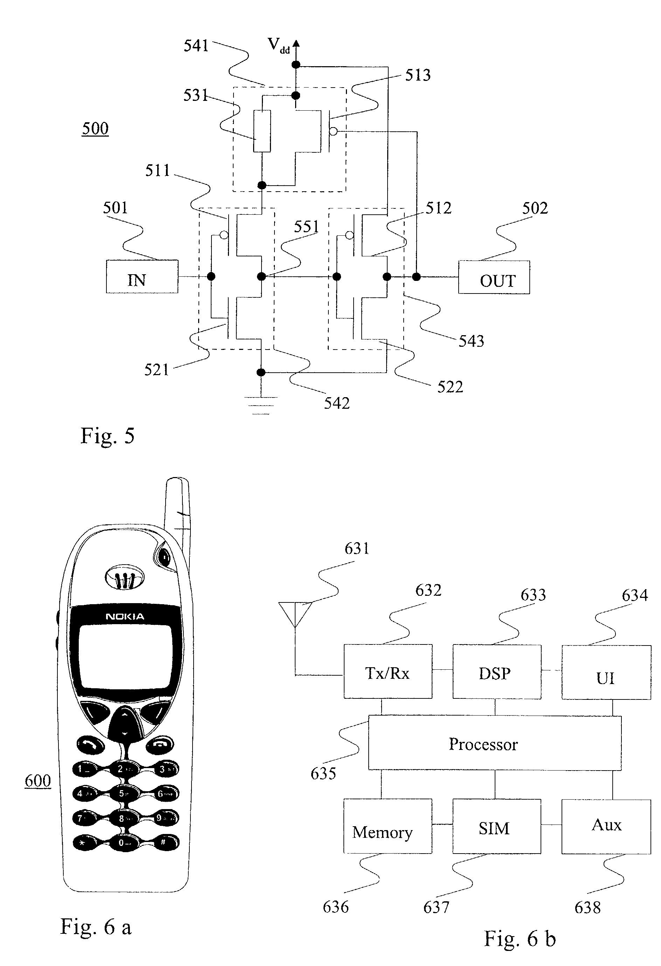

Figure 6 b shows a simplified block diagram of a mobile phone incorporating a logical level shifting circuit according to the present invention.

A level shifting circuit 500 according to the present invention is shown in Figure 5. The level shifting circuit 500 comprises a first CMOS inverter 542 and a second CMOS inverter 543. The first CMOS inverter 542 and the second CMOS inverter 543 each comprise a PMOS transistor 511, 512 and an NMOS transistor 521, 522. The gate of the PMOS transistor 511, 512 is connected to the gate of the corresponding NMOS transistor 521, 522 forming an input of the respective CMOS inverter 542, 543. The drain of the PMOS transistor 511, 512 is connected to the drain of the corresponding NMOS transistor 521, forming an output of the respective CMOS inverter 542, 543. A node 551 is shown as the output of the first CMOS inverter 542. The node 551 is connected to the input of the second CMOS inverter 543. Thus, a cascade connection is formed between the first CMOS inverters 542 and the second CMOS inverter 543. An IN-port 501 works as the 500. Respectively, an OUT-port 502 works as the output of the second CMOS inverter 543 and as an output of the level shifting circuit 500. The level shifting circuit 500 further comprises a leakage current limiting circuit 541 comprising a PMOS transistor 513 and a resistor 531 connected in parallel between the drain and the source of the PMOS transistor 513. The source of the PMOS transistor 513 is connected to operating voltage V_{DD} (via a voltage supply point) and the drain of the PMOS transistor 513 is connected to the source of the PMOS transistor 511.

An example of operation of the level shifting circuit 500 is now described. The IN-port 501 is connected to a voltage level of 2 V corresponding to logical 1 at the IN-port 501 side of the level shifting circuit 500. The operating voltage V_{DD} is 3V corresponding to logical 1 level at the OUT-port 502 side of the level shifting circuit 500. A positive gate-to-source voltage causes the NMOS transistor 521 to conduct and thus to connect the node 551 to ground potential. As a result the gates of the NMOS transistor 522 and the PMOS transistor 512 are grounded due to which the NMOS transistor 522 is closed and the PMOS transistor 512 conducts. The PMOS transistor 512 thus connects the OUT-port 502 to the operating voltage V_{DD} (via the voltage supply point). At the same, the operating voltage V_{DD} is also applied to the gate of the PMOS transistor 513, thus keeping the PMOS transistor 513 in nonconductive state. Hence, there is a leakage current I_{L} flowing from the operating voltage V_{DD} through the resistor 531, the PMOS transistor 511 and the NMOS transistor 521 to the ground potential because of the PMOS transistor 511 not completely closing due to the gate voltage still being lower than the operating voltage V_{DD}. This leakage current I_{L}, however, will be limited to a small value by the resistor 531.

The value for the resistor 531 is high in order to limit the leakage current I_{L}. Setting the value to infinity, for example, by deleting the resistor 531 completely from the circuit diagram of the level shifting circuit 500, would set the leakage current I_{L} to zero. However, this would make the level shifting circuit 500 inoperable in the case where the voltage at the IN-port 501 goes from the voltage corresponding to logical 1 to the voltage corresponding to logical 0.

Let us now consider the case where the IN-port 501 is set to the voltage corresponding to logical 0. Grounding the gates of the PMOS transistor 511 and the NMOS transistor 521 causes the NMOS transistor 521 to be closed and the PMOS transistor 511 to be in a conductive state. The node 551 is then connected to the operating voltage V_{DD} through the resistor 531. Because no current passes through the gates of the PMOS transistor 512 and the NMOS transistor 522 the limited current flowing through the resistor 531 is enough to cause the voltage of the node 551 rapidly to exceed a breakover point U_{B} of the second CMOS inverter 543 after which the NMOS transistor 522 conducts and grounds the OUT-port 502. At the same time the gate of the PMOS transistor 513 is also grounded causing the PMOS transistor 513 to conduct and thus to connect the node 551 to the operating voltage V_{DD}.

It is clearly seen that setting the value of the resistor 531 to infinity would block the function of the level shifting circuit 500, since a transition from the voltage level corresponding to logical 1 to the voltage level corresponding to logical 0 at the IN-port 501 would not cause any change at the OUT-port 502. Instead, the OUT-port 502 would constantly remain on a voltage level corresponding to logical 1. Setting the value of the resistor 531 too high would make the level shifting circuit 500 function very slowly. On the other hand, a value, which is too low, would not limit the leakage current in the case in which the IN-port 501 is on the voltage level corresponding to logical 1. There is clearly an optimal range for the value of the resistor 531. In a preferred embodiment of the present invention the value for the resistor 531 is set to 500 kΩ.

A level shifting circuit 500 is specially advantageous when implemented in a mobile phone 600 as shown in Figure 6 a. The mobile phone 600 may be constructed according to any cellular or cordless standard, including, but not limited to, the Global System for Mobile communications (GSM), the Universal Mobile Telephone System (UMTS), the Digital Enhanced Cordless Telephone (DECT) and the Personal Handyphone System (PHS).

Figure 6 b shows a block diagram of the mobile phone 600. The mobile phone 600 comprises an antenna 631, a transceiver 632, a DSP block 633, a user interface (UI) 634, a processor 635 and a memory 636. It may further comprise a Subscriber Identification Module (SIM) 637 for storing subscriber specific data and/or an auxiliary device 638 integrated in the same casing with or connected to the mobile phone 600. A signal, such as a speech signal, is received by the mobile phone 600 via the UI 634. The signal is processed by the DSP block 633 and is then passed to the transceiver 632. The transceiver 632 transmits the signal modulated on a carrier via the antenna 631 to a base station (not shown). Downlink signals transmitted by a base station (not shown) are received by the antenna 631, passed further to the transceiver 632 and processed by the DSP block 633. These signals may then be output by the UI 634. The mobile phone 600 is controlled by the processor 635, which is run by an operating code stored in the memory 636. The memory 636 may also be used to store other parameters necessary for the mobile phone 600 or the connection to the base station.

In most modern mobile phones besides the processor 635, the memory 636 and the DSP block 633, also the transceiver 632 is at least partly implemented by digital technology. The DSP block 633 may further comprise several circuits each implemented by digital technology. These circuits may use different voltage levels corresponding to logical 1. In cases in which the voltage levels corresponding to logical 1 are differing from each other in these circuits, level shifts are used to connect an output of one such digital circuit to an input of another such digital circuit. This can be done by using a level shifting circuit according to the present invention.

The transceiver 632 needs high voltages for amplifying the signal to be transmitted to a base station. Part of the blocks shown in Figure 6 b may be using just one, low voltage level corresponding to logical 1. Due to this, the level shifting circuit 500 is implemented as a part of the transceiver 632 in a preferred embodiment of the invention. It is understood by a person skilled in the art that it can equally well be implemented on the same chip with the processor 635, the memory 636 or it can be a further separate element, such as illustrated by the auxiliary device 638.

Although described in the context of presently preferred embodiments, it should be noted that a number of modifications to these teachings may occur to the person skilled in the art. It will thus be understood by the persons skilled in the art that even though the invention has been shown and described with respect to preferred embodiments thereof, several changes may be made therein without departing from the scope and the spirit of the invention. These changes and modifications, which are clear to those skilled in the art, are intended to be included within the scope of the present invention as defined by the enclosed claims.

## Claims

1. A level shifting circuit for shifting a first voltage level to a second voltage level comprising a first inverter and a second inverter, an output of the first inverter being connected to an input of the second inverter, an input of the first inverter forming an input port of the level shifting circuit for inputting the first voltage level and an output of the second inverter forming an output port of the level shifting circuit for outputting the second voltage level, a voltage supply point via which the level shifting circuit is supplied with an operating voltage **characterised in that** the level shifting circuit further comprises a leakage current limiting circuit connected in series between the first inverter and the voltage supply point for limiting a leakage current through the logic level shifting circuit.

2. A level shifting circuit according to claim 1, **characterised in that** the first voltage level is corresponding to a first logical 1 in a first digital circuit and the second voltage level is corresponding to a second logical 1 in a second digital circuit.

3. A level shifting circuit according to claim 1 or claim 2, **characterised in that** the second voltage level corresponds to the operating voltage.

4. A level shifting circuit according to any one of the preceding claims, **characterised in that** at least one of the first inverter and the second inverter is implemented using CMOS technology.

5. A level shifting circuit according to any one of the preceding claims, **characterised in that** at least one of the first inverter and the second inverter comprises a PMOS transistor and an NMOS transistor, the gate of the PMOS transistor being connected to the gate of the NMOS transistor forming the input of the inverter and the drain of the PMOS transistor being connected to the drain of the NMOS transistor forming the output of the inverter.

6. A level shifting circuit according to any one of the preceding claims, **characterised in that** the leakage current limiting circuit comprises a PMOS transistor the drain of the PMOS transistor being connected to the first inverter, the source of the PMOS transistor being connected to the operating voltage, the gate of the PMOS transistor being connected to the output of the level shifting circuit and a resistor being connected between the drain of the PMOS transistor and the source of the PMOS transistor to allow a limited current flow from the operating voltage to the first CMOS inverter in a situation when the channel of the PMOS transistor is shut.

7. A level shifting circuit according to claim 6, **characterised in that** the resistor value is set so as not substantially to slow down the function of the level shifting circuit.

8. A level shifting circuit according to claim 6 or claim 7 **characterised in that** the resistor has a value in a range between 100 kΩ and 1 MΩ.

9. A digital logic circuitry comprising a plurality of subcircuits, each subcircuit using one of a plurality of voltage levels, a first voltage level of the plurality of voltage levels differing from a second voltage level of the plurality of voltage levels, a first subcircuit of the plurality of subcircuits being a level shifting circuit for shifting the first voltage level output from a second subcircuit of the plurality of subcircuits to the second voltage level for inputting to a third subcircuit of the plurality of subcircuits, the first subcircuit comprising a first inverter and a second inverter, an output of the first inverter being connected to an input of the second inverter, an input of the first inverter forming an input port of the first subcircuit for inputting the first voltage level and an output of the second inverter forming an output port of the first subcircuit for outputting the second voltage level, a voltage supply point via which the first subcircuit is supplied with an operating voltage **characterised in that** the first subcircuit further comprises a leakage current limiting circuit connected in series between the first inverter and the voltage supply point for limiting a leakage current through the first subcircuit.

10. A digital logic circuitry according to claim 9, **characterised in that** the first voltage level is corresponding to a first logical 1 in the second subcircuit and the second voltage level is corresponding to a second logical 1 in the third subcircuit.

11. A digital logic circuitry according to claim 9 or claim 10, **characterised in that** the second voltage level corresponds to the operating voltage.

12. A digital logic circuitry according to any one of the preceding claims 9 to 11, **characterised in that** at least one of the first inverter and the second inverter is implemented using CMOS technology.

13. A digital logic circuitry according to any one of the preceding claims 9 to 12, **characterised in that** at least one of the first inverter and the second inverter comprises a PMOS transistor and an NMOS transistor, the gate of the PMOS transistor being connected to the gate of the NMOS transistor forming the input of the inverter and the drain of the PMOS transistor being connected to the drain of the NMOS transistor forming the output of the inverter.

14. A digital logic circuitry according to any one of the preceding claims 9 to 13, **characterised in that** the leakage current limiting circuit comprises a PMOS transistor the drain of the PMOS transistor being connected to the first inverter, the source of the PMOS transistor being connected to the operating voltage, the gate of the PMOS transistor being connected to the output of the second subcircuit and a resistor being connected between the drain of the PMOS transistor and the source of the PMOS transistor to allow a limited current flow from the operating voltage to the first inverter in a situation when the channel of the PMOS transistor is shut.

15. A digital logic circuitry according to claim 14, **characterised in that** the resistor value is set so as not substantially to slow down the function of the logic level shifting circuit.

16. A digital logic circuitry according to claim 14 or claim 15, **characterised in that** the resistor has a value in a range between 100 kΩ and 1 MΩ.

17. A mobile phone comprising a level shifting circuit for shifting a first voltage level, output from a first digital circuit, to a second voltage level for inputting to a second digital circuit, the level shifting circuit comprising a first inverter and a second inverter, an output of the first inverter being connected to an input of the second inverter, an input of the first inverter forming an input port of the level shifting circuit for inputting the first voltage level and an output of the second inverter forming an output port of the level shifting circuit for outputting the second voltage level, a voltage supply point via which the level shifting circuit is supplied with an operating voltage **characterised in that** the level shifting circuit further comprises a leakage current limiting circuit connected in series between the first inverter and the voltage supply point for limiting a leakage current through the logic level shifting circuit.

18. A mobile phone according to claim 17, **characterised in that** the first voltage level is corresponding to a first logical 1 in a first digital circuit and the second voltage level is corresponding to a second logical 1 in a second digital circuit.

19. A mobile phone according to claim 17 or claim 18, **characterised in that** the second voltage level corresponds to the operating voltage.

20. A mobile phone according to any one of the preceding claims 17 to 19, **characterised in that** at least one of the first inverter and the second inverter is implemented using CMOS technology.

21. A mobile phone according to any one of the preceding claims 17 to 20, **characterised in that** at least one of the first inverter and the second inverter comprises a PMOS transistor and an NMOS transistor, the gate of the PMOS transistor being connected to the gate of the NMOS transistor forming the input of the inverter and the drain of the PMOS transistor being connected to the drain of the NMOS transistor forming the output of the inverter.

22. A mobile phone according to any one of the preceding claims 17 to 21, **characterised in that** the leakage current limiting circuit comprises a PMOS transistor the drain of the PMOS transistor being connected to the first inverter, the source of the PMOS transistor being connected to the operating voltage, the gate of the PMOS transistor being connected to the output of the second subcircuit and a resistor being connected between the drain of the PMOS transistor and the source of the PMOS transistor to allow a limited current flow from the operating voltage to the first inverter in a situation when the channel of the PMOS transistor is shut.

23. A mobile phone according to claim 22, **characterised in that** the resistor value is set so as not substantially to slow down the function of the logic level shifting circuit.

24. A mobile phone according to claim 22 or claim 23, **characterised in that** the resistor has a value in a range between 100 kΩ and 1 MΩ.
